# EUROPÄISCHE PATENTSCHRIFT

(11) **EP 2 477 232 B1**
(45) Veröffentlichungstag und Bekanntmachung des Hinweises auf die Patenterteilung: **20.05.2015**
(21) Anmeldenummer: 11193422.0
(22) Anmeldetag: 14.12.2011
(51) Int. Cl.: H01L 31/048, H01L 31/052

(54) **Solarmodul**
Solar module
Module solaire

(30) Priorität: 05.01.2011 DE 102011000041
(43) Veröffentlichungstag der Anmeldung: 18.07.2012
(73) Patentinhaber: BPE e. K., 90542 Eckental (DE)
(72) Erfinder: Hornig, Wolfgang, 90542 Eckental (DE)
(74) Vertreter: Kaufmann, Sigfrid

(56) Entgegenhaltungen:
- WO-A1-2010/061637
- DE-A1- 4 240 058
- US-A1- 2006 054 211
- US-A1- 2008 135 093
- US-A1- 2009 129 210
- US-A1- 2010 229 920

## Beschreibung

Die Erfindung betrifft ein Solarmodul mit einer Solarzelle und einem Lichtlenkungselement zur Leistungssteigerung, insbesondere bei ungünstigen Lichtverhältnissen. Das Solarmodul ist besonders für eine feste Installation an senkrechten Gebäudewänden, in Fenstern und für den Einsatz in beweglichen bzw. tragbaren Geräten, wie z. B. Taschenrechnern, geeignet.

Das Dokument US 2009/0129210 A beschreibt ein Solarmodul.

Um die Leistung von solarthermischen und fotovoltaischen Solarzellen zu steigern, werden bereits Konzentratoren eingesetzt, die einfallendes Licht auf der Solarzelle konzentrieren, wodurch eine hohe Bestrahlungsstärke erzielt wird. Als Konzentratoren werden Sammellinsen, Hohlspiegel, Prismen oder Kegel verwendet.

So sind z. B. aus dem Bereich der Solarthermie sog. Parabolrinnenkollektoren bekannt. Parabolrinnenkollektoren bestehen aus Spiegeln, die die Form einer parabolisch gewölbten Rinne haben, und einem in der Brennlinie der Rinne verlaufenden Absorberohr. Sonnenlicht, das auf die Kollektoren trifft, wird durch die Spiegel gebündelt und auf das Absorberrohr gelenkt. Entsprechende Spiegel zur Bündelung des Sonnenlichts werden auch in den solarthermischen CPC-Vakuumröhrenkollektoren (Compound Parabolic Concentrator), wie z. B. aus DE 10 2006 060 012 A1 bekannt, eingesetzt.

Mit dem Einsatz von Konzentratoren sind bei günstigen Lichtverhältnissen, d. h. bei einem nur geringen Verschmutzungsgrad von Konzentrator und Solarzelle sowie einer exakten Ausrichtung beider Elemente zum einfallenden Sonnenlicht, zwar erhebliche Leistungssteigerungen gegenüber Solarzellen ohne Konzentrator möglich, bei ungünstigen Lichtverhältnissen (hoher Verschmutzungsgrad und ungünstiger Einfallswinkel des Lichts) erbringen Solarzellen mit Konzentratoren jedoch oft geringere Leistungen als solche ohne Konzentratoren. Deshalb müssen Solarzellen mit Konzentratoren häufig gereinigt werden und verfügen meist über eine Nachführeinrichtung, die eine exakte Ausrichtung zum Sonnenlicht ermöglicht, was jedoch mit hohem personellem bzw. technischem Aufwand verbunden ist. Nachteilig sind auch die vergleichsweise hohen Anschaffungskosten von Solarzellen mit Konzentratoren sowie der Energieverbrauch für entsprechende Stell- bzw. Nachführeinrichtungen, wobei diese Einrichtungen zusammen mit den Konzentratoren zudem einen erheblichen Platzbedarf haben.

In DE 10 2008 014 618 A1 wird eine Anordnung zum Konzentrieren von Solarstrahlung auf Solarzellen beschrieben, wobei mehrere voneinander beabstandete Konzentratoren in Form von Strahlungsteilern vorgesehen sind und jeweils eine Solarzelle in einer Lücke zwischen zwei Strahlungsteilern angeordnet ist. Damit ein solcher Strahlungsteiler als Konzentrator wirken kann, müssen zwei Solarzellen derart hinter dem Strahlungsteiler angeordnet werden, dass die Solarzellen bezüglich der einfallenden Solarstrahlung nicht von dem Strahlungsteiler überdeckt bzw. abgeschattet sind und, zusätzlich zu der an dem Strahlungsteiler vorbeilaufenden Solarstrahlung, jeweils eines der beiden von dem Strahlungsteiler erzeugten Strahlenbündel auf jede der beiden Solarzellen trifft. Der Konzentrator kann lediglich für senkrecht oder nahezu senkrecht auf ihn einfallende Solarstrahlung eingesetzt werden (entsprechend wird auch der Einsatz einer Nachführeinrichtung vorgeschlagen), da bei flacheren Einfallswinkeln aus Geometriegründen keine Strahlungsteilung mehr erfolgt.

Der Erfindung liegt die Aufgabe zu Grunde, ein Solarmodul mit mindestens einer thermischen, thermoelektrischen oder fotovoltaischen Solarzelle (bzw. einem thermischen, thermoelektrischen oder fotovoltaischen Solarelement) und mindestens einem Lichtlenkungselement bereitzustellen, mittels dessen ein effektives Umwandeln von Solarenergie in thermische oder elektrische Energie ermöglicht ist. Die Solarzelle bzw. das Solarelement kann z. B. eine fotovoltaische Zelle, von der Solarstrahlungsenergie direkt in elektrische Energie umwandelbar ist, ein thermischer Solarkollektor, von dem Solarstrahlungsenergie direkt in thermische Energie umwandelbar ist, oder aber auch ein thermoelektrischer Generator (auch kurz als "Thermogenerator-Element" oder "Themogenerator-Zelle" bezeichnet), von dem mittels einer Temperaturdifferenz unter Ausnutzung des Seebeck-Effekts elektrische Energie bereitstellbar ist, sein.

Die Aufgabe der Erfindung wird durch die kennzeichnenden Merkmale des Anspruchs 1 gelöst. Weitere Ausführungen der Erfindung ergeben sich aus den abhängigen Ansprüchen.

Gemäß der Erfindung wird ein Solarmodul mit einer (fotovoltaischen oder solarthermischen) Solarzelle, die sich ggf. aus mehreren kleinen Solarzellen zusammensetzt, und mindestens einem Lichtlenkungselement, das v. a. bei ungünstigen Lichtverhältnissen und Einstrahlungswinkeln zur Erhöhung der von der Solarzelle abgegebenen Leistung dient, bereitgestellt.

Nach Maßgabe der Erfindung ist als das (mindestens eine) Lichtlenkungselement eine Folie oder Scheibe aus einem transparenten Material verwendet. Die (flächige) Solarzelle und das (flächige) Lichtlenkungselement sind einander gegenüberliegend angeordnet, d. h. die von den Außenkonturen (bzw. Außenumfangsrändern) der Solarzelle und des Lichtlenkungselements umschlossenen Flächen überlappen einander bezüglich ihrer Normalenrichtungen. Zum Beispiel kann vorgesehen sein, dass die Außenkontur des Lichtlenkungselements (bzw. deren Projektion entlang der Normalenrichtung der von der Außenkontur des Lichtlenkungselements umschlossenen Fläche auf die Ebene der Solarzelle) an allen Seiten über die Außenkontur der Solarzelle hinausragt oder mit derselben zusammenfällt. Die Solarzelle und das Lichtlenkungselement sind zudem in einem Winkel von 0° bis 45° zueinander angeordnet, d. h. die Ebenen, in denen die Fläche der Solarzelle (bzw. des Solarelements) und die Fläche des Lichtlenkungselements liegen, bilden einen Schnittwinkel zwischen 0° und 45°. Die der Solarzelle zugewandte Seitenfläche des Lichtlenkungselements weist mehrere lang gezogene (d. h. eine (wesentlich) größere Längsabmessung als Querabmessung aufweisende), zueinander parallel verlaufende gerade Prismen gleicher Höhe auf (wobei die Prismenhöhe hier den - quer zur Längsrichtung eines jeweiligen Prismas verlaufenden - Abstand zwischen der Spitze des Prismas und der derselben gegenüberliegenden rechteckigen Seitenfläche des Prismas kennzeichnet), d. h. ist mit einer entsprechenden Form ausgebildet. Die Grundfläche der Prismen hat die Form eines gleichschenkligen Dreiecks mit einem Winkel an der Spitze, der 10° bis 60° beträgt. Die Spitzen der gleichschenkligen Dreiecke weisen von dem Lichtlenkungselement (d. h. von der Folie bzw. Scheibe) weg, die Symmetrieachsen der Dreiecke stehen senkrecht auf der der Solarzelle abgewandten Seitenfläche bzw. der Hauptfläche des Lichtlenkungselements, und nebeneinander liegende Prismen berühren sich mit ihren stumpfen Kanten (d. h. zueinander parallel verlaufende, benachbarte Prismen grenzen mit ihren Längsseiten aneinander an). Die Prismen weisen mit ihren spitzen Kanten (gebildet durch die Parallelverschiebung des Winkels an der Spitze des gleichschenkligen Dreiecks) in Richtung der Solarzelle. Die aktive Seite der Solarzelle und die mit den Prismen versehene Seite des Lichtlenkungselements liegen einander gegenüber.

Es wurde festgestellt, dass mittels des erfindungsgemäßen Solarmoduls bzw. mittels des Lichtlenkungselements die von der Solarzelle erzeugte Leistung insbesondere bei ungünstigen Lichtverhältnissen, nämlich bei einem flachen Einfallswinkel des Lichts auf das Solarmodul bzw. das Lichtlenkungselement, bei diffusem Licht und bei einer Verschmutzung der Komponenten, um bis zu 50% gesteigert werden kann. Die Solarzelle des Solarmoduls kann z. B. vertikal bzw. lotrecht oder auch horizontal angeordnet sein.

Das Lichtlenkungselement besteht bevorzugt aus PMMA (Polymethylmethacrylat) oder aus einer strukturierten Glasplatte, wobei die Abstände zwischen den Spitzen benachbarter Prismen zwischen 10 und 5000 µm betragen. Kleinere Abstände der Prismenspitzen ermöglichen es, die Lichtlenkungselemente in geringerem Abstand zu den Solarzellen montieren, was besonders bei einer parallelen Anordnung von Lichtlenkungselement und Solarzelle von Vorteil ist. Andererseits treten bei Abständen im Mikrometerbereich Beugungseffekte auf, die sich mit der durch die Prismenstruktur verursachten Lichtlenkung überlagern.

Darüber hinaus hat es sich gezeigt, dass, um optimale Ergebnisse zu erhalten, die Prismengröße und -form auch an die Art der verwendeten Solarzelle (monokristallines, polykristallines oder amorphes Silizium; GaAs-, CdTe- Halbleiter; Beschichtungshalbleiter, z. B. aus CulnSe₂; LED-, OLED- Halbleiteranordnungen) anzupassen sein kann.

Eine weitere Verbesserung des Wirkungsgrads des Solarmoduls kann dadurch erreicht werden, dass die Seite des Lichtlenkungselements, welche der Seite mit den Prismen gegenüberliegt (d. h. die der Solarstrahlung zugewandte und von der Solarzelle abgewandte Seitenfläche des Lichtlenkungselements), mit einer Struktur aus Mikro-Tetraedern und/oder mit einer antireflektierenden Beschichtung versehen wird.

In einer bevorzugten Ausführungsform ist die Solarzelle eine rechteckförmige Solarzelle und das Lichtlenkungselement rahmenförmig ausgeführt, d. h., es weist eine rechteckförmige Außenkontur sowie einen rechteckförmigen Durchbruch auf, und ist parallel zu der rechteckförmigen Solarzelle ausgerichtet. Die gesamte Außenkontur des Lichtlenkungselements (d. h. der Außenumfang des von dem Lichtlenkungselement gebildeten Rahmens) überragt gemäß dieser Ausführung die Ränder der Solarzelle und der Durchbruch des Lichtlenkungselements ist seinerseits vollständig von der Solarzelle überdeckt. Die größte Steigerung der Ausbeute kann erzielt werden, wenn das rahmenförmige Lichtlenkungselement 20-50 % der aktiven Fläche der Solarzelle überdeckt und zudem jeder der vier Seitenteile des rahmenförmigen Lichtlenkungselements Prismen aufweist, deren lange Seiten parallel zu derjenigen Außenkante der Solarzelle verlaufen, die von dem betreffenden Seitenteil überdeckt wird.

Der Einsatz des rahmenförmigen Lichtlenkungselements bewirkt z. B., dass (bei einem vertikal bzw. lotrecht in Ost-West-Ausrichtung angeordneten Solarmodul) durch die beiden senkrecht stehenden Seitenteile von Osten bzw. von Westen her auf das Solarmodul fallendes Licht auf die Solarzelle gelenkt wird, das oben liegende horizontale Seitenteil die von oben einfallende direkte Sonnenstrahlung auf die Solarzelle lenkt und das unten liegende horizontale Seitenteil vom Boden reflektiertes Licht auffängt. Darüber hinaus lenken alle vier Seitenteile diffuses Licht auf die Solarzelle.

Bei kommerziellen fotovoltaischen Solarmodulen sind die Solarzellen üblicherweise in einem flachen, quaderförmigen Gehäuse, dessen Seitenwände als dünne Platten ausgeführt sind und dessen Oberseite mit einer transparenten Scheibe bedeckt ist, untergebracht, wobei die aktive Seite der Solarzelle der transparenten Scheibe zugewandt ist.

Gemäß einer Ausführungsform weist das Solarmodul ein Gehäuse auf, das z. B. als flaches, quaderförmiges Gehäuse ausgestaltet ist, dessen Seitenwände als dünne Platten ausgeführt sind und dessen (zum Empfangen von Solarstrahlung vorgesehene) Oberseite als transparente Scheibe ausgeführt ist; wobei die Solarzelle mit ihrer aktiven Seite bzw. Fläche der transparenten Scheibe zugewandt in dem Gehäuse aufgenommen ist. Gemäß dieser Ausführungsform kann das Lichtlenkungselement z. B. ein rahmenförmiges Lichtlenkungselement sein und derart angeordnet sein, dass seine Prismen mit ihren spitzen Kanten zu der Solarzelle weisen. Das Lichtlenkungselement ist z. B. als selbstklebende Folie ausgeführt und auf der ins Innere des Gehäuses gewandten Seite der transparenten Scheibe angebracht. Alternativ kann auch vorgesehen sein, das Lichtlenkungselement durch entsprechende Formgebung der Scheibe integral mit derselben auszubilden. Zum Beispiel kann die Scheibe eine Scheibe sein, die im mittleren Bereich plan und im Randbereich genauso wie das oben beschriebene rahmenförmige Lichtlenkungselement ausgeformt ist (d. h. an jedem der vier Rahmenteile parallel zur jeweiligen Rahmenseite verlaufende Prismen aufweist). Falls zur Verbesserung des Wirkungsgrads ein größerer Abstand zwischen dem rahmenförmigen Lichtlenkungselement und der Solarzelle erforderlich ist, kann die Solarzelle auch innerhalb des Gehäuses vom Lichtlenkungselement weg versetzt werden.

In einer weiteren Anwendung des rahmenförmigen Lichtlenkungselements wird dieses in Verbindung mit einer (z. B. in die Scheibe eines Fensters integrierten bzw. als Fensterscheibe fungierenden) transparenten Solarzelle (z. B. basierend auf einer transparenten dünnen Halbleiterbeschichtung) eingesetzt. Das Lichtlenkungselement wird dabei z. B. rahmenförmig entlang des Außenrandes der transparenten Solarzelle verlaufend ausgebildet, z. B. innerhalb eines entsprechenden Fensterrahmens derart angeordnet, dass es mit seiner Außenkontur an die Innenseite des Fensterrahmens angrenzt und gleichzeitig, bedingt durch den rechteckförmigen Durchbruch im Lichtlenkungselement, 50 % bis 80 % des Fensters transparent bleiben bzw. von dem Lichtlenkungselement nicht überdeckt werden.

Auf diese Weise kann zum einen die Leistung der transparenten Solarzelle mittels Lichtlenkung gesteigert und zum anderen z. B. der Raum hinter einem entsprechend ausgebildeten Fenster zusätzlich durch das (mittels des Lichtlenkungselements) in ihn gelenkte Licht erhellt werden, wodurch Energie für Leuchtmittel zum Beleuchten des Raumes eingespart werden kann.

In einer alternativen Ausführungsform wird ein rechteckförmiges Lichtlenkungselement, bei dem die spitzen Kanten der Prismen alle parallel zueinander (z. B. horizontal) verlaufen bzw. bei dem alle Prismen parallel zueinander angeordnet sind, eingesetzt. Hohe Leistungssteigerungen von bis zu 50% können bei Solarzellen, die vertikal bzw. lotrecht, z. B. an einer Hauswand, angeordnet sind, erreicht werden, wobei z. B. das Lichtlenkungselement parallel zu der Solarzelle bzw. den Solarzellen installiert bzw. angeordnet wird. Bei waagerecht bzw. horizontal angeordneten Solarzellen oder bei Solarzellen, die, wie z. B. bei auf einem Dach montierten Solarzellen, unter einem Winkel zur Horizontalen gekippt positioniert sind, wird insbesondere bei diffusem Licht oder bei ungünstigen Sonnenständen (z. B. am Abend) eine nachhaltige Leistungssteigerung erreicht, wenn das Lichtlenkungselement um einen Winkel von bis zu 45° gegenüber der Solarzelle gekippt angeordnet ist.

Um die strukturierte Oberfläche der Lichtlenkungselemente vor Schmutz und Feuchtigkeit zu schützen, können die Lichtlenkungselemente mittels eines Rahmens, der den Raum zwischen der Solarzelle und dem Lichtlenkungselement abdichtet, unter jeweils dem vorgesehenen Winkel an den Solarzellen befestigt sein. Zur Vermeidung von Schwitz- bzw. Kondenswasser kann der Rahmen mit einer Belüftungsöffnung, die mit einer für Wasser undurchlässigen, jedoch für Wasserdampf durchlässigen Membran verschlossen ist, versehen sein. Es hat sich überraschenderweise gezeigt, dass diese Anordnungen aus Solarzelle und Lichtlenkungselement sehr unempfindlich gegen Verschmutzung und sogar gegenüber dünnen, aufliegenden Eis- oder Schneeschichten sind. Falls dennoch erforderlich, lässt sich die außen liegende, glatte Seite des Lichtlenkungselements jedoch auch vergleichsweise einfach reinigen.

Bei Solarzellen, die fest in Geräten, wie z. B. Taschenrechnern, Mobiltelefonen, Uhren oder sonstigen transportablen Solarzellen-Vorrichtungen, installiert sind, und bei denen sich in Abhängigkeit von der Lage des Geräts der Einstrahlwinkel des Lichts ständig ändert, wird ein Winkel zwischen Solarzelle und Lichtlenkungselement eingestellt, welcher der am häufigsten auftretenden Lage der Solarzelle beim Betrieb des Geräts entspricht.

Bei der Herstellung des Lichtlenkungselements wird z. B. in einem ersten Schritt ein Urwerkzeug hergestellt, indem ein aus Stahl, Diamant, Hartmetall, Glas oder Keramik bestehendes, prismenförmiges Prägewerkzeug, das einen dreieckförmigen Querschnitt und einen in Richtung eines Rohlings weisenden, spitzen Winkel von 10° bis 60° aufweist, unter Verwendung einer Positioniereinrichtung, wie z. B. einem Mikro- oder Nanohärteprüfgerät (z. B. nach der Methode von Vickers), an einer Seite des Rohlings beginnend auf den Rohling gepresst wird. Anschließend wird das Prägewerkzeug, dem Verlauf einer Linie folgend, um einen Abstand, der maximal der Breite des Prägewerkzeugs entspricht, versetzt und erneut auf den Rohling gepresst. Der Vorgang wird solange wiederholt, bis eine durchgängige Vertiefung mit dreieckförmigem Querschnitt, welche die gewünschte Länge aufweist, auf dem Rohling erzeugt wurde.

Anschließend wird das Prägewerkzeug z. B. parallel um einen definierten Abstand zur bereits erzeugten Vertiefung versetzt und analog eine weitere durchgängige Vertiefung erzeugt. Der Abstand, um den das Prägewerkzeug versetzt wird, ist derart zu wählen, dass durch das Einbringen mehrerer Vertiefungen auf der strukturierten Oberfläche Prismen mit scharfkantigen, spitzen Winkeln 10° bis 60° entstehen, die vom Rohling weg weisen und sich jeweils mit ihren stumpfen Kanten berühren. Entsprechend wird solange Vertiefung an Vertiefung gereiht, bis ein Oberflächenanteil des Rohlings in der gewünschten Größe strukturiert ist.

Der Rohling kann z. B. ein plattenförmiger Rohling sein. Bei einem plattenförmigen Rohling wird z. B. an einer Ecke begonnen und das Prägewerkzeug um einen halben Abstand bezüglich einer Kante des Rohlings nach innen (in Richtung der zu prägenden Fläche des Rohlings) versetzt. Anschließend wird beginnend von der anderen, dazu senkrecht stehenden Kante solange Vertiefung um Vertiefung im Rohling erzeugt, bis seine gesamte Fläche strukturiert ist.

Es kann auch vorgesehen sein, dass der Rohling ein walzenförmiger Rohling ist. Bei einem walzenförmigen Rohling kann an einer beliebigen Stelle mit der Erzeugung der ersten Vertiefung begonnen werden, es ist jedoch drauf zu achten, dass der Radius ein Vielfaches des Abstands, um den jeweils versetzt wird, beträgt. Die so erzeugten Urwerkzeug werden anschließend zur Fertigung der Lichtlenkungselemente abgeformt, z. B. mittels Heißpressens oder Heißwalzens.

Als Rohlinge für plattenförmige Urwerkzeuge können z. B. Platten aus Keramikwerkstoffen, wie z. B. Aluminiumoxid, oder Metallplatten verwendet werden. Die Lichtlenkungselemente werden dann z. B. durch Abformen der Oberflächen der Urwerkzeuge mittels Heißpressens (z. B. auf PMMA) hergestellt.

Alternativ kann das Urwerkzeug nach dessen Herstellung mittels galvanischen Beschichtens (z. B. mit Nanonickel) repliziert werden, wobei die so erzeugten Formen bzw. Nickelformen für die Herstellung der Lichtlenkungselemente verwendet werden.

Darüber hinaus ist es auch möglich, ein walzenförmiges Urwerkzeug einzusetzen und dieses mittels Heißwalzens auf transparentem Kunststoff oder Glas abzuformen.

Alternativ können zur kostengünstigen Herstellung von großflächigen Lichtlenkungselementen z. B. Platten (z. B. Polymerplatten) mittels Fräs- und Sägewerkzeugen, die mit prismatisch geformten Diamanten besetzt sind, direkt bearbeitet werden; statt der Diamanten können auch Keramik- oder Hartmetallpyramiden, die mit einer diamantähnlichen Beschichtung versehen sind, eingesetzt sein. Die optische Qualität der auf den Platten erzeugten prismatischen Oberflächenstrukturen ist jedoch prinzipbedingt geringer als die von Oberflächenstrukturen, die mit Prägeverfahren (direkt oder indirekt) hergestellt wurden.

Des Weiteren ist auch eine Herstellung der Lichtlenkungselemente mittels PolymerKunstoffspritzgießens denkbar.

Die Erfindung wird nachfolgend anhand von Ausführungsbeispielen mit Bezug auf die beiliegenden Zeichnungen näher erläutert, wobei gleiche oder ähnliche Merkmale mit gleichen Bezugszeichen versehen sind; hierzu zeigen schematisch:
- Fig. 1:: ein Solarmodul gemäß einer Ausführungsform mit einem rahmenförmigen Lichtlenkungselement,
- Fig. 2:: ein Solarmodul gemäß einer Ausführungsform mit rechteckförmigem Lichtlenkungselement und vertikal angeordneter Solarzelle,
- Fig. 3:: ein Solarmodul gemäß einer Ausführungsform mit rechteckförmigem Lichtlenkungselement und horizontal angeordneter Solarzelle,
- Fig. 4:: ein Prägewerkzeug und ein teilweise hergestelltes Urwerkzeug,
- Fig. 5:: das Abformen eines plattenförmigen Urwerkzeugs,
- Fig. 6:: das Abformen eines walzenförmigen Urwerkzeugs.

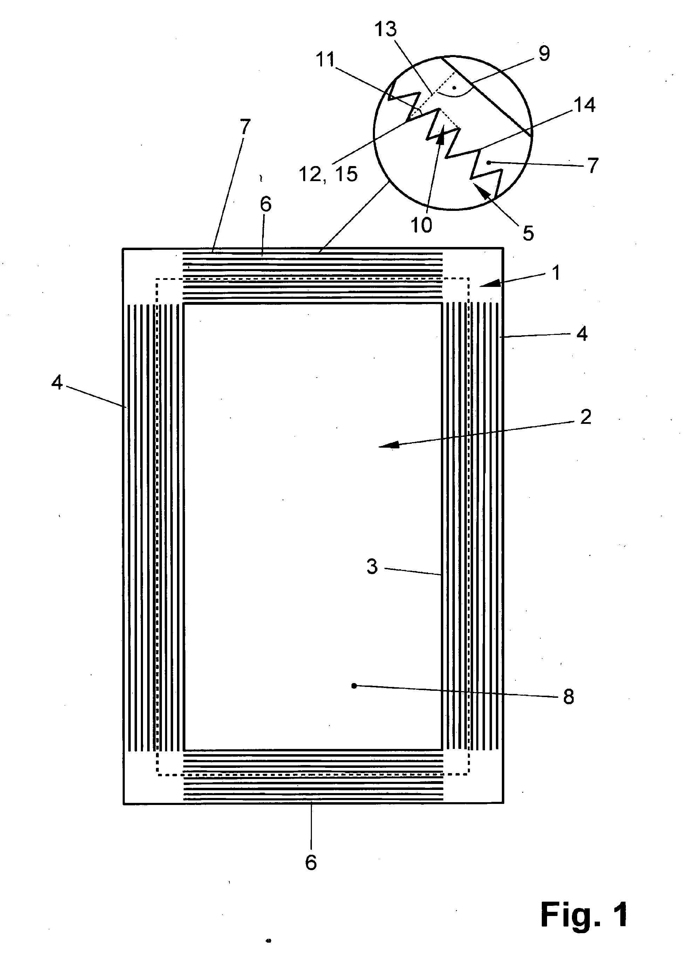

In Fig. 1 ist ein Solarmodul mit einem rahmenförmigen Lichtlenkungselement 1 aus PMMA und einer Solarzelle 2, die von dem Lichtlenkungselement 1 vollständig überdeckt wird und die ihrerseits den rechteckförmigen Durchbruch 3 des Lichtlenkungselements 1 vollständig ausfüllt bzw. überdeckt, dargestellt. Die Solarzelle 2 und das Lichtlenkungselement 1 sind einander gegenüberliegend angeordnet, wobei die Außenkontur der Solarzelle 2 (in Figur 1 veranschaulicht durch die gestrichelte Linie) vollständig von der Außenkontur des Lichtlenkungselements 1 überdeckt ist. Die vertikalen Seitenteile 4 des Lichtlenkungselements 1 sind auf der der Solarzelle 2 zugewandten Seite 5 des Lichtlenkungselements 1 mit vertikal verlaufenden, die horizontalen Seitenteile 6 des Lichtlenkungselements 1 mit horizontal verlaufenden, länglichen Prismen 7 versehen; d. h. an jedem der vier Rahmenabschnitte des Lichtlenkungselements 1 sind mehrere parallel zueinander und parallel zu dem jeweiligen Rahmenabschnitt verlaufende Prismen 7 ausgebildet. Die aktive Seite 8 der Solarzelle 2 weist in Richtung der Prismen 7 bzw. ist der mit den Prismen 7 ausgebildeten Seitenfläche 5 des Lichtlenkungselements 1 zugewandt. Des Weiteren ist die von der Solarzelle 2 abgewandte Seite 9 der Oberfläche des Lichtlenkungselements 1 mit einer Antireflexionsbeschichtung (nicht dargestellt) versehen.

Die Grundfläche 10 der Prismen 7 hat die Form eines gleichschenkligen Dreiecks, dessen Winkel 11 an der Spitze 12 hier als Beispiel ca. 40° beträgt. Die Symmetrieachsen 13 der gleichschenkligen Dreiecke stehen senkrecht auf der der Solarzelle 2 abgewandten Seite 9 der Lichtlenkungselemente 1 und die (im Vergleich zu der Spitze) stumpfen Kanten 14 der Prismen 7 grenzen aneinander, d. h. die benachbarte Prismen 7 grenzen mit ihren Längsseiten aneinander. Die Spitzen 12 der gleichschenkligen Dreiecke der Grundfläche 10 (bzw. die durch Parallelverschiebung der Grundfläche gebildeten, spitzen Kanten 15 der Prismen) weisen in Richtung der aktiven Seite 8 der Solarzelle 2.

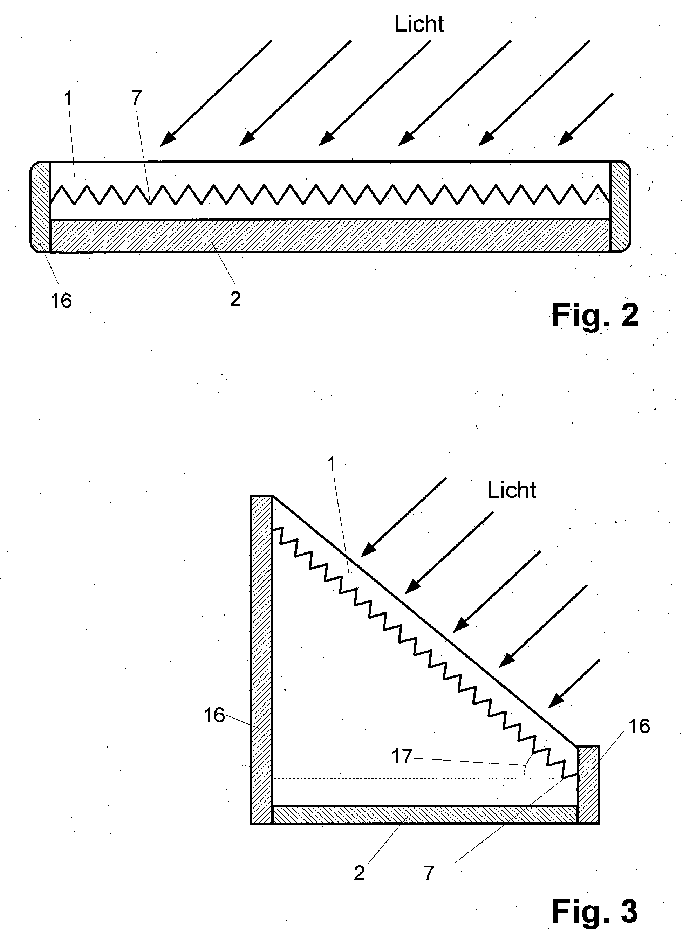

Fig. 2 zeigt ein Solarmodul mit einem rechteckförmigen Lichtlenkungselement 1, bei dem die Prismen 7 (bzw. deren spitze Kanten 15) alle parallel zueinander (hier: horizontal) verlaufen, und einer vertikal bzw. lotrecht (z. B. an einer Häuserwand) angeordneten Solarzelle 2, die mittels eines wasserdichten Rahmens 16 parallel und mit einem definierten Abstand (bei dem im zeitlichen Mittel die Solarzelle 2 die höchste Leistung abgibt) zu dem Lichtlenkungselement 1 angeordnet ist. Bei horizontal angeordneter Solarzelle 2 (Fig. 3) wird mit dem Lichtlenkungselement 1 nur dann eine optimale Leistungssteigerung erzielt, wenn dieses - z. B. mittels eines Rahmens 16 - in einem Winkel 17, der gemäß Figur 3 als Beispiel ca. 40° beträgt, gekippt zur Solarzelle 2 angebracht ist.

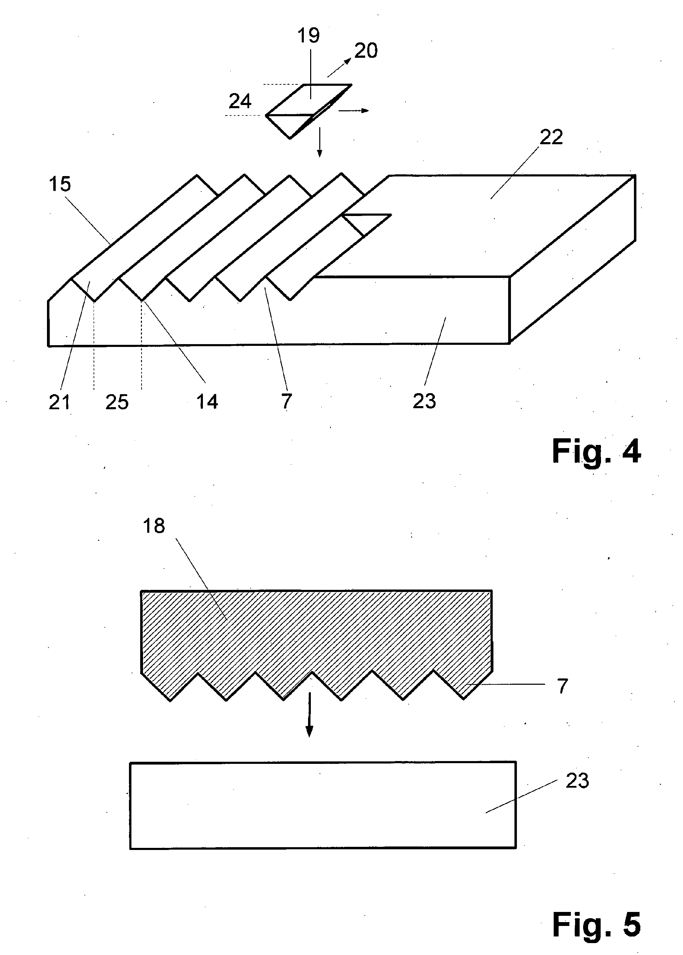

Wie in Fig. 4 dargestellt, können als Beispiel zur Herstellung eines plattenförmigen Urwerkzeugs 18 mittels eines prismenförmigen Prägewerkzeugs 19 mit dreieckförmigem Querschnitt und einem spitzen Winkel (von gemäß Figur 4 als Beispiel ca. 40°), das mit Hilfe eines Härteprüfgeräts 20 nach Vickers (schematisch dargestellt durch Pfeile) positioniert wird, zeilenweise Vertiefungen 21 in die Oberfläche 22 eines plattenförmigen Rohlings 23 eingeprägt werden. Vor dem sukzessiven Prägen einer neuen durchgängigen Vertiefung 21, bei welchem jeweils dem Verlauf einer Linie folgend das Prägewerkzeug 19 um eine seiner Breite 24 entsprechende Distanz weiterbewegt wird, wird das Prägewerkzeug um jeweils einen festen Abstand 25 versetzt. Der Abstand 25 ist so gewählt, dass die stumpfen Kanten 14 benachbarter Prismen 7 auf dem Urwerkzeug 18 aneinander grenzen und gleichzeitig die Prismen 7 scharfkantige Winkel 11 (von hier ca. 40°) erhalten.

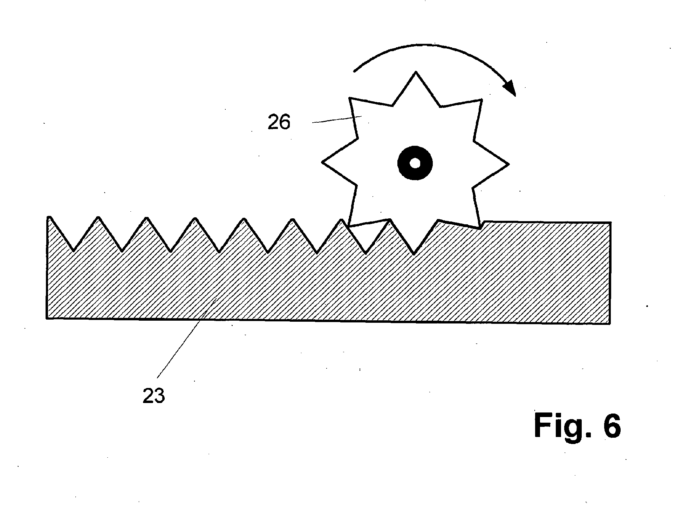

Zur Herstellung eines entsprechenden Lichtlenkungselements 1 wird als Beispiel entweder die Prismenstruktur des plattenförmigen Urwerkzeugs 18 (siehe Fig. 5) durch Heißpressen oder diejenige eines walzenförmigen Urwerkzeugs 26 (siehe Fig. 6) durch Heißwalzen auf eine Platte aus PMMA übertragen.

**Liste der verwendeten Bezugszeichen**
- 1: Lichtlenkungselement
- 2: Solarzelle
- 3: Durchbruch
- 4: vertikales Seitenteil
- 5: der Solarzelle zugewandte Seite des Lichtlenkungselements
- 6: horizontales Seitenteil
- 7: Prisma
- 8: aktive Seite der Solarzelle
- 9: von der Solarzelle abgewandte Seite des Lichtlenkungselements
- 10: Grundfläche
- 11: Winkel an der Spitze
- 12: Spitze
- 13: Symmetrieachse
- 14: stumpfe Kante des Prismas
- 15: spitze Kante des Prismas
- 16: Rahmen
- 17: Winkel zwischen Lichtlenkungselement und Solarzelle
- 18: Plattenförmiges Urwerkzeug
- 19: Prägewerkzeug
- 20: Härteprüfgerät/Positioniereinrichtung
- 21: Vertiefung
- 22: Oberfläche des Rohlings
- 23: Rohling
- 24: Breite des Prägewerkzeugs
- 25: Abstand
- 26: walzenförmiges Urwerkzeug

## Patentansprüche

1. Solarmodul mit einer Solarzelle (2) und einem Lichtlenkungselement (1) in Form einer Folie oder Scheibe aus einem transparenten Material, wobei die Solarzelle (2) und das Lichtlenkungselement (1) einander gegenüberliegend angeordnet sind, und wobei die der Solarzelle (2) zugewandte Seitenfläche des Lichtlenkungselements (1) zueinander parallel verlaufende gerade Prismen (7) aufweist, deren Grundfläche (10) die Form eines gleichschenkligen Dreiecks mit einem Winkel (11) an der Spitze (12) von 10° bis 60° hat, wobei die Spitzen (12) der Dreiecke von dem Lichtlenkungselement weg weisen, die Symmetrieachsen (13) der Dreiecke senkrecht zu der der Solarzelle (2) abgewandten Seitenfläche (9) des Lichtlenkungselements (1) stehen und nebeneinander liegende Prismen (7) aneinander angrenzen,
**dadurch gekennzeichnet, dass**
die Solarzelle (2) eine rechteckförmige Solarzelle ist und das Lichtlenkungselement (1) rahmenförmig ausgeformt ist, eine rechteckförmige Außenkontur sowie einen rechteckförmigen Durchbruch (3) aufweist und parallel zu der rechteckförmigen Solarzelle (2) ausgerichtet ist, wobei die gesamte Außenkontur des Lichtlenkungselements (1) über die Solarzelle (2) übersteht, der Durchbruch (3) vollständig von der Solarzelle (2) überdeckt ist und das Lichtlenkungselement (1) 20-50 % der aktiven Seite der Solarzelle (8) überdeckt, und jeder der vier Seitenteile (4, 6) des rahmenförmigen Lichtlenkungselements (1) Prismen (10) aufweist, die mit ihrer Längsrichtung parallel zu derjenigen Außenkante der Solarzelle (2) verlaufen, die von diesem Seitenteil (4, 6) überdeckt wird.

2. Solarmodul nach Anspruch 1, **dadurch gekennzeichnet, dass** der Abstand zwischen den Spitzen zweier benachbarter Prismen (7) 10 bis 5000 µm beträgt.

3. Solarmodul nach einem der Ansprüche 1 oder 2, **dadurch gekennzeichnet, dass** das Lichtlenkungselement (1) scheibenförmig ausgeführt ist und aus Polymethylmethacrylat oder aus Glas besteht.

4. Solarmodul nach einem der Ansprüche 1 bis 3, **dadurch gekennzeichnet, dass** die der Solarzelle abgewandte Seitenfläche (9) des Lichtlenkungselements (1) eine Struktur aus Mikro-Tetraedern aufweist und/oder mit einer antireflektierenden Beschichtung versehen ist.

5. Solarmodul nach einem der Ansprüche 1 bis 4, **dadurch gekennzeichnet, dass** die dem Lichtlenkungselement (1) zugewandte Seitenfläche der Solarzelle (2) mit mikrooptischen Elementen zur Lichtkonzentration versehen ist.

6. Solarmodul nach einem der Ansprüche 1 bis 5, **dadurch gekennzeichnet, dass** sie ferner ein flaches, quaderförmiges Gehäuse aufweist, dessen Seitenwände als dünne Platten ausgeführt sind und dessen Oberseite mit einer transparenten Scheibe bedeckt ist, wobei die Solarzelle (2) in dem Gehäuse aufgenommen ist und die aktive Seite (8) der Solarzelle (2) der transparenten Scheibe zugewandt ist, und wobei das Lichtlenkungselement ein rahmenförmiges Lichtlenkungselement (1) ist und auf der ins Innere des Gehäuses gewandten Seite der transparenten Scheibe angeordnet ist.

7. Solarmodul nach einem der Ansprüche 1 bis 6, **dadurch gekennzeichnet, dass** die Solarzelle eine transparente Solarzelle (2) ist.

8. Solarmodul nach einem der Ansprüche 1 bis 7, **dadurch gekennzeichnet, dass** die Solarzelle (2) horizontal oder vertikal ausgerichtet ist.

9. Solarmodul nach Anspruch 8, **dadurch gekennzeichnet, dass** die Prismen (7) auf der Seitenfläche des Lichtlenkungselements (1) mit ihrer Längsrichtung horizontal verlaufen.

10. Solarmodul nach einem der Ansprüche 1 bis 9, **dadurch gekennzeichnet, dass** die Solarzelle ein thermoelektrischer Generator ist.

## Claims

1. A solar module comprising a solar cell (2) and a light deflection element (1) in the form of a film or a pane made of a transparent material, wherein the solar cell (2) and the light deflection element (1) are disposed opposite one another, and wherein the surface of the side of the light deflection element (1) that faces the solar cell (2) has straight prisms (7), which extend parallel to one another, wherein the base surface (10) of said prisms has the shape of an isosceles triangle having an angle (11) of 10° to 60° at the tip (12), wherein the tips (12) of the triangles point away from the light deflection element, the axes of symmetry (13) of the triangles are perpendicular to the surface of the side (9) of the light deflection element (1) facing away from the solar cell (2), and adjacent prisms (7) adjoin one another,
**characterized in that**
the solar cell (2) is a rectangular solar cell, and the light deflection element (1) has the shape of a frame, a rectangular outer contour, and a rectangular opening (3), and is oriented parallel to the rectangular solar cell (2), wherein the entire outer contour of the light deflection element (1) extends beyond the solar cell (2), the opening (3) is completely covered by the solar cell (2), and the light deflection element (1) covers 20-50% of the active side of the solar cell (8), and each of the four side parts (4, 6) of the frame-shaped light deflection element (1) has prisms (10), which extend, in the longitudinal direction thereof, parallel to the outer edge of the solar cell (2) that is covered by this side part (4, 6).

2. The solar module according to claim 1, **characterized in that** the separation between the tips of two adjacent prisms (7) is 10 to 5000 µm.

3. The solar module according to any one of claims 1 or 2, **characterized in that** the light deflection element (1) is pane-shaped and is made of polymethylmethacrylate or glass.

4. The solar module according to any one of claims 1 to 3, **characterized in that** the surface of the side (9) of the light deflection element (1) facing away from the solar cell has a structure formed of micro-tetrahedrons and/or is provided with an anti-reflective coating.

5. The solar module according to any one of claims 1 to 4, **characterized in that** the surface of the side of the solar cell (2) facing the light deflection element (1) is provided with micro-optical elements for concentrating light.

6. The solar module according to any one of claims 1 to 5, **characterized in that** said solar module furthermore comprises a flat, cuboid housing, the side walls of which are designed as thin plates and the top side of which is covered with a transparent pane, wherein the solar cell (2) is accommodated in the housing and the active side (8) of the solar cell (2) faces the transparent pane, and wherein the light deflection element is a frame-shaped light deflection element (1) and is disposed on the side of the transparent pane facing the interior of the housing.

7. The solar module according to any one of claims 1 to 6, **characterized in that** the solar cell is a transparent solar cell (2).

8. The solar cell according to any one of claims 1 to 7, **characterized in that** the solar cell (2) is oriented horizontally or vertically.

9. The solar module according to claim 8, **characterized in that** the prisms (7) extend, in the longitudinal direction thereof, horizontally on the surface of the side of the light deflection element (1).

10. The solar module according to any one of claims 1 to 9, **characterized in that** the solar cell is a thermoelectric generator.

## Revendications

1. Module solaire avec une cellule solaire (2) et un élément de guidage de lumière (1) sous la forme d'une feuille ou d'une vitre constituée d'un matériau transparent, dans lequel la cellule solaire (2) et l'élément de guidage de lumière (1) sont agencés l'un en face de l'autre, et dans lequel la surface latérale de l'élément de guidage de lumière (1) tournée vers la cellule solaire (2) présente des prismes droits (7) parallèles les uns aux autres, dont la surface de base (10) présente la forme d'un triangle isocèle avec un angle (11) de 10° à 60° au sommet (12), dans lequel les sommets (12) des triangles sont détournés de l'élément de guidage de lumière, les axes de symétrie (13) des triangles s'étendent perpendiculairement à la surface latérale (9) de l'élément de guidage de lumière (1) détournée de la cellule solaire (2) et les prismes adjacents (7) sont juxtaposés,
**caractérisé en ce que**
la cellule solaire (2) est une cellule solaire rectangulaire et l'élément de guidage de lumière (1) est façonné en forme de cadre, présente un contour extérieur rectangulaire et une percée rectangulaire (3), tout en étant orienté parallèlement à la cellule solaire (2) rectangulaire, sachant que la totalité du contour extérieur de l'élément de guidage de lumière (1) fait saillie au-delà de la cellule solaire (2), la percée (3) est entièrement recouverte par la cellule solaire (2) et l'élément de guidage de lumière (1) recouvre de 20 à 50% du côté actif (8) de la cellule solaire, et chacune des quatre parties latérales (4, 6) de l'élément de guidage de lumière (1) en forme de cadre comporte des prismes (10) s'étendant, avec leur direction longitudinale, parallèlement au bord extérieur de la cellule solaire (2) qui est recouvert par cette partie latérale (4, 6).

2. Module solaire selon la revendication 1, **caractérisé en ce que** l'espacement entre les sommets de deux prismes (7) voisins mesure entre 10 et 5000 µm.

3. Module solaire selon l'une des revendications 1 ou 2, **caractérisé en ce que** l'élément de guidage de lumière (1) est conçu en forme de disque et constitué de polyméthylacrylate ou de verre.

4. Module solaire selon l'une des revendications 1 à 3, **caractérisé en ce que** la surface latérale (9) de l'élément de guidage de lumière (1) qui est détournée de la cellule solaire présente une structure en micro-tétraèdres et/ou est pourvue d'un revêtement anti-réfléchissant.

5. Module solaire selon l'une des revendications 1 à 4, **caractérisé en ce que** la surface latérale de la cellule solaire (2) qui est tournée vers l'élément de guidage de lumière (1) est pourvue d'éléments micro-optiques pour la concentration de la lumière.

6. Module solaire selon l'une des revendications 1 à 5, **caractérisé en ce qu'**il comporte en outre un boîtier plat parallélépipédique, dont les parois latérales sont conçues comme des plaques fines et dont la face supérieure est recouverte d'une vitre transparente, la cellule solaire (2) étant accueillie dans le boîtier et le côté actif (8) de la cellule solaire (2) étant tourné vers la vitre transparente, et l'élément de guidage de lumière étant un élément de guidage de lumière (1) en forme de cadre, agencé sur le côté de la vitre transparente qui est tourné vers l'intérieur du boîtier.

7. Module solaire selon l'une des revendications 1 à 6, **caractérisé en ce que** la cellule solaire est une cellule solaire (2) transparente.

8. Module solaire selon l'une des revendications 1 à 7, **caractérisé en ce que** la cellule solaire (2) est orientée horizontalement ou verticalement.

9. Module solaire selon la revendication 8, **caractérisé en ce que** les prismes (7) s'étendent horizontalement avec leur direction longitudinale sur la face latérale de l'élément de guidage de lumière (1).

10. Module solaire selon l'une des revendications 1 à 9, **caractérisé en ce que** la cellule solaire est un générateur thermoélectrique.
